(19) Europäisches Patentamt
European Patent Office
Office européen des brevets

(11) **EP 3 146 318 B1**

(12) **EUROPÄISCHE PATENTSCHRIFT**

(45) Veröffentlichungstag und Bekanntmachung des Hinweises auf die Patenterteilung:
**06.11.2019 Patentblatt 2019/45**

(51) Int Cl.:
**G01N 27/02** (2006.01)    **G01V 3/10** (2006.01)
**H03K 17/95** (2006.01)    **G01B 7/00** (2006.01)

(21) Anmeldenummer: **15724298.3**

(22) Anmeldetag: **22.05.2015**

(86) Internationale Anmeldenummer:
**PCT/EP2015/061373**

(87) Internationale Veröffentlichungsnummer:
**WO 2015/177337 (26.11.2015 Gazette 2015/47)**

(54) **VERFAHREN ZUR ERMITTLUNG WENIGSTENS EINES PHYSIKALISCHEN PARAMETERS MITTELS EINER SENSOREINHEIT**

METHOD FOR DETECTING AT LEAST ONE PHYSICAL PARAMETER BY MEANS OF A SENSING UNIT

PROCÉDÉ POUR MESURER AU MOINS UN PARAMÈTRE PHYSIQUE PAR UN ENSEMBLE DE DÉTECTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.05.2014 DE 102014007491
22.07.2014 DE 102014010671**

(43) Veröffentlichungstag der Anmeldung:
**29.03.2017 Patentblatt 2017/13**

(73) Patentinhaber: **Reime, Gerd
77815 Bühl (DE)**

(72) Erfinder: **Reime, Gerd
77815 Bühl (DE)**

(74) Vertreter: **Reinhardt, Harry
RPK Patentanwälte
Reinhardt, Pohlmann und Kaufmann
Partnerschaft mbB
Grünstraße 1
75172 Pforzheim (DE)**

(56) Entgegenhaltungen:
**EP-A2- 1 059 542    DE-A1-102012 019 329
US-A- 4 724 709    US-A- 5 729 143**

**Beschreibung**

Die Erfindung betrifft ein Verfahren zur Ermittlung wenigstens eines physikalischen Parameters mittels einer Sensoreinheit nach dem Oberbegriff des Anspruches 1.

Aus dem Stand der Technik sind verschiedenste Verfahren zur Ermittlung wenigstens eines physikalischen Parameters mittels einer Sensoreinheit bekannt. Diesen Messverfahren ist häufig eine Temperaturabhängigkeit gemeinsam, was im Folgenden anhand induktiver Messsysteme erläutert wird, wenngleich diese Aussagen auch auf beliebige andere Messprinzipien zutreffen können wie insbesondere kapazitive oder resistive Messsysteme, aber auch optische oder chemische Messsysteme, sofern der physikalische Messwert in einen elektrischen Wert umgewandelt wird.

Induktive Verfahren zur Detektion eines induktiv wirksamen Gegenstandes sind hinlänglich bekannt. Produktbeispiele reichen von industriellen Annährungssensoren über Positionsencoder bis zum Schatzsuchgerät. Diese Sensoren sind in der Regel mit einem Spulensystem versehen, bei dem ein elektromagnetisches Feld periodisch ausgesendet wird und die Beeinflussung des Feldes durch den induktiv wirksamen Gegenstand (Target) gemessen wird.

Vorzugsweise werden induktive Systeme eingesetzt, bei denen Sende- und Empfangsspule magnetisch entkoppelt sind. Das ausgesendete Magnetfeld bewirkt bei Abwesenheit des Targets keine Wirkung in der Empfangsspule. Ein metallischer Gegenstand in der Nähe des sendenden Feldes verändert die Magnetfeldlinien bzw. die induzierten Wirbelströme. Beim Abklingen der Wirbelströme wird ein Feld im Gegenstand erzeugt, das wiederum von der Empfangsspule empfangen werden kann. Die empfangenen Ströme sind naturgemäß sehr klein und müssen für eine weitere Auswertung verstärkt werden. Diese Verstärkung kann je nach Ausführung des Sensorssystems mehr als den Faktor 1000 betragen. Ein dabei auftretendes Problem ist in der Praxis der Temperatureinfluss auf die Analogbausteine im Empfangspfad.

Aus dem Stand der Technik wie der dem Oberbegriff des Anspruches 1 zu Grunde liegenden DE-A 10 2012 019 329 sind daher auch Systeme bekannt, bei denen das Empfangssignal auch bei Metaleinfluss auf Null geregelt wird. Dazu wird z.B. das in einer Empfangsspule entstehende Empfangssignal durch einen analog erzeugten Kompensationswert z.B. in Form einer periodisch geschalteten Spannung im Wesentlichen zu Null geregelt. Das Ausgangssignal der Sensoreinheit wird im Wesentlichen auf die Grundwelle der Anregung reduziert und bedarfsweise wird mittels einer Pulsweitenmodulation das Ausgangssignal im gesamten Phasenraum zu Null geregelt. Ausgewertet wird allerdings nicht das Ausgangssignal, sondern das Regelsignal, um daraus Änderungen im Detektionsbereich zu ermitteln, z.B. die Annäherung eines Gegenstands. Ein nicht optimaler Punkt sind die verwendeten analogen Signale, mit denen das Empfangssignal des Spulensystems ganz oder teilweise zu Null kompensiert wird. Die Erzeugung analog geregelter Signale bedingt Halbleiterkomponenten, die wiederum relativ temperaturkritisch sind, so dass viel Aufwand für eine präzise temperaturunabhängige Messung notwendig ist.

Aus der älteren, nachveröffentlichten deutschen Patentanmeldung DE 10 2013 226 887 ist bekannt, dass in dem im Empfangspfad ermittelten Signal gleichzeitig Informationen über die Form und/oder Legierung des Targets bzw. Größe der Fläche des Targets im Detektionsbereich des Spulensystems enthalten sind. Bewegung oder Position des Targets sind dabei durch die Formänderung und/oder Legierungsänderung unabhängig vom Abstand des Targets zum Spulensystem bestimmbar. Wird diese Information durch eine Vektoranalyse aufbereitet, lassen sich dadurch die gewünschten weiteren Informationen differenziert entnehmen. Dazu erfolgt eine kontinuierliche Regelung in einem geschlossenen Regelkreis, sodass das Empfangssignal immer zu "Null" geregelt wird. Damit führt ein Target im Detektionsbereich des Sende-/Empfangsspulensystems grundsätzlich zu einer Änderung der Regelsignale. Dem Regelsignal ist damit also eine Abweichung vom ausgeregelten Zustand als Information über das Target immanent. Wird ein Target verwendet, das eine sich entlang einer Messrichtung veränderliche Form oder Zusammensetzung aufweist, und nach entsprechender Verrechnung der Regelgrößen deren Abweichung zu einem ausgeregelten Ausgangszustand in einer Vierquadrantendarstellung aufgetragen, lässt sich feststellen, dass der Winkel eines gedachten Vektors zur horizontalen Achse des Koordinatensystemsein Maß für die Bewegung des Targets in Messrichtung ist, während der Betrag des gedachten Vektors ein Maß für den Abstand des Targets normal zur Messrichtung ist. Damit kann auf die Position des Targets entlang der Messrichtung getrennt vom Abstand des Targets normal zur Messrichtung oder je nach Target auf die Legierung und die Form des Targets geschlossen werden.

Aus der US 5,729, 143 A ist ein induktiver Metalldetektor bekannt, bei dem in einer Kalibrierungsphase unter Anwendung einer Pulsweiten- und Phasenmodulation unerwünschte Empfangssignale ausgelöscht werden. Mit der so erfolgten Einstellung wird anschließend kontinuierlich gemessen, wobei die Ausgangssignale der Empfangsspule für die Messung ausgewertet werden. Eine vergleichbare Vorgehensweise erfolgt auch bei einem Metalldetektor nach der US 4,030,026 A, um mineralische Böden oder andere Hintergrundbedingungen von den Messungen auszuschließen.

Ausgehend von diesem Stand der Technik liegt der vorliegenden Erfindung die Aufgabe zu Grunde, ein temperaturstabiles, volldigitales Messsystem zu schaffen.

Diese Aufgabe wird durch ein Verfahren zur Ermittlung wenigstens eines physikalischen Parameters mittels einer Sensoreinheit mit den Merkmalen des Anspruches 1 gelöst.

Die Erfindung geht von folgenden Überlegungen aus, die im Folgenden am Beispiel eines induktiven Annäherungssensors erläutert werden, wenngleich das Verfahren auch für beliebige andere Messprinzipien verwendet werden kann wie insbesondere kapazitive oder resistive Messsysteme, aber auch optische und chemische Messsysteme, sofern der physikalische Messwert in einen elektrischen Wert umgewandelt wird:

- In der Regel sind elektrische Werte, die ein solcher Sensor liefert sehr klein, so dass eine Verstärkung oder entsprechende Signalaufbereitung erfolgt, bevor diese Signale ausgewertet werden können. Heutige A/D Wandler in Mikroprozessoren sind zwar schon sehr empfindlich, um ein analoges Signal in ein digitales Signal umzusetzen, jedoch entstehen bei einigen Sensoren so kleine Wertänderungen, die noch erfasst werden müssen, so dass auch ein solcher A/D Wandler überfordert ist. Die Erfindung geht nun davon aus, dass so ein kleines Signal mit einem ebenso kleinen, aber vollständig digital erzeugten Signal zu Null kompensiert werden kann. Eine Verstärkung dieses "Nullsignals" kann nun beliebig hoch verstärkt werden und dem A/D Wandler des Mikroprozessors zugeführt werden. Wird dieses Nullsignal durch eine geschlossene Regelung ständig auf Null gehalten, haben Temperatureinflüsse und dadurch hervorgerufene Verstärkungsänderungen im System keinen Einfluss mehr auf den Regelwert. Der Vorteil liegt auch darin, dass rein digitale Signale einer Pulsweitenmodulation (PWM) nur passiv z.B. mittels Widerständen auf einen sehr geringen Wert heruntergeteilt werden müssen, um das Signal am Entstehungsort in diesem Fall der Empfangsspule im gesamten Phasenraum digital zu kompensieren. Digitale Signale sind in der Regel nicht temperaturkritisch, da sie nur aus Null und Eins bestehen.
- Für den beispielhaften Fall eines induktiven Sensors wird ein rein digitales Signal, das aus mehreren PWM-Abschnitten besteht, dem Signal der Empfangsspule direkt am Entstehungsort hinzugefügt. Hierbei tritt zwar ein Oberwellenspektrum in Erscheinung. Dieses lässt sich durch Trennen der Oberwellenanteile des Empfangssignals von der Grundwelle unterdrücken. Im einfachsten Falle geschieht dies durch eine Resonanzbildung im Empfangsspulensystem auf die Grundwelle.
- Die Pulsweitenmodulation lässt sich digital in diskreten Schritten variieren und unterliegt keinem Temperatureinfluss (Allgemein werden Taktfrequenzen vom Quarz erzeugt und dieser kann hier als stabil angenommen werden). Je nach Pulsweite wird damit ein variabler Energieanteil dem Signal im Empfangspfad periodisch zugeführt. Um eine optimale Auslöschung des Ausgangssignals der Empfangsspule zu erreichen, muss entweder die Energie variabel in der Menge (Länge der PWM) und variabel zum richtigen Zeitpunkt pro Phase zugeführt werden oder die Energie muss in der Phase an zwei festgelegten Zeitpunkten getrennt voneinander zugeführt werden, z.B. bei 0° und 180° und bei 90° und 270° jeweils zueinander invertiert. In allen Fällen ist nur ein rein digital erzeugtes Signal notwendig, um ein Ausgangssignal der Empfangsspule kontinuierlich zu Null zu regeln. Alle nachfolgenden Verstärkerstufen dienen nur der Entscheidung, ob das Empfangssignal ungleich Null ist und können damit auch als ein digitales System angesehen werden.

In der Praxis kann eine so hohe Verstärkung verwendet werden, dass am Ausgang des Verstärkers im Empfangspfad nur noch das Verstärkerrauschen anliegt und als Bewertungsgrundlage für die Pulsweitenmodulation dieses nur noch statistisch auf high- und low-Ereignisse digital ausgewertet wird. Im Gegensatz zur analogen temperaturabhängigen Messung, deren Messsignal von der Amplitude abhängig ist, erhält man bei diesem Messprinzip den Messwert aus der temperaturunabhängigen eindeutigen digitalen Information. Diese digitale Information wird digital weiterverarbeitet und aus diesen Werten die Stellgröße für die Pulsweitenmodulation berechnet.

Gängige Methoden der Regelungstechnik wie z.B. PID-Regelalgorithmen können in der digitalen Signalverarbeitung auch hier angewandt werden.

Die so gewonnenen Werte des digitalen Korrektursignals repräsentieren somit vollständig die induktiven Einflüsse des Targets auf das Sende-/Empfangsspulensystem.

Vorzugsweise wird bei Verwendung einer relativ hohen Anregungsfrequenz von z.B. 400 kHz über eine Kombination mehrerer, z.B. vier Pulsweitenmodulationen ein Tristate-Korrektursignal erzeugt, das an z.B. vier Punkten im Phasenraum die induktive Wirkung des Targets zu Null regelt. Diese vier Punkte sind im Phasenraum um jeweils 90° zueinander versetzt. Es können auch mehr Punkte gewählt werden, wenn mit einer niedrigen Frequenz, z.B. kleiner 10 kHz gearbeitet wird, da der Prozessor dann ausreichend Rechenzeit zur Berechnung mehrere Punkte im Phasenraum hat.

Weitere Vorteile ergeben sich aus den Unteransprüchen und der nachfolgenden Beschreibung bevorzugter Ausführungsbeispiele.

Kurzbeschreibung der Figuren

Im Folgenden wir die Erfindung anhand von in den beigefügten Figuren dargestellten Ausführungsbeispielen näher erläutert. Es zeigen:

Fig. 1     eine schematische Darstellung betreffend die Signalverarbeitung,

Fig. 2        Signalverläufe im Rahmen der Regelung des Empfangssignals aus der Sensoreinheit zu Null,

Fig. 3        ein schematisches Blockschaltbild der Systemkomponenten nach der älteren Patentanmeldung DE 10 2013 226 887,

Fig. 4        ein Ablaufdiagramm für die Vorgehensweise bei der Messwertauswertung mit einer Sensoreinheit gemäß Fig. 3,

Fig. 5        eine dreidimensionale Seitenansicht eines Targets mit als Sensoreinheit zugeordnetem Sende-/Empfangsspulensystem,

Fig. 6a, 6b   eine Draufsicht auf die Darstellung gemäß Fig. 5 bei Verschiebung des Targets entlang der n-Achse und bei Verschiebung des Targets entlang der Messachse m,

Fig. 7, 8     eine Vierquadrantendarstellung der Abweichungen der Regelsignale,

Ausführliche Beschreibung bevorzugter Ausführungsbeispiele

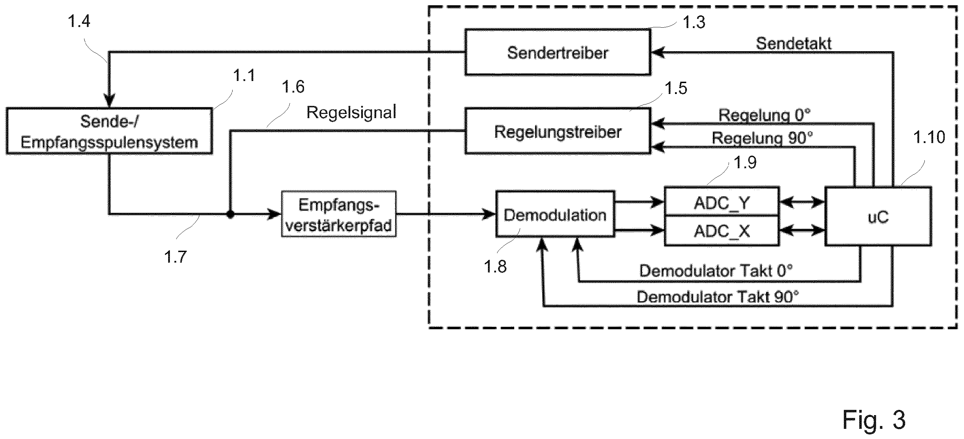

Die Erfindung wird jetzt beispielhaft unter Bezug auf die beigefügten Zeichnungen näher erläutert. Allerdings handelt es sich bei den Ausführungsbeispielen nur um Beispiele, die nicht das erfinderische Konzept auf eine bestimmte Anordnung beschränken sollen. Bevor die Erfindung im Detail beschrieben wird, ist darauf hinzuweisen, dass sie nicht auf die jeweiligen Bauteile der Vorrichtung sowie die jeweiligen Verfahrensschritte beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn zudem in der Beschreibung oder in den Ansprüchen die Einzahl oder unbestimmte Artikel verwendet werden, bezieht sich dies auch auf die Mehrzahl dieser Elemente, solange nicht der Gesamtzusammenhang eindeutig etwas Anderes deutlich macht. Zum besseren Verständnis wird im Rahmen dieser Anmeldung zunächst in den Fig. 3 bis 8 das grundsätzliche Messverfahren erläutert, wie es in der älteren Patentanmeldung DE 10 2013 226 887 offenbart ist. Dabei wird die Erfindung im Folgenden am Beispiel eines induktiven Annäherungssensors erläutert, wenngleich das Verfahren auch für beliebige andere Messprinzipien verwendet werden kann wie insbesondere kapazitive oder resistive Messsysteme, aber auch optische und chemische Messsysteme, sofern der physikalische Messwert in einen elektrischen Wert umgewandelt wird. Insofern wäre in Fig. 3 lediglich das Sende-/Empfangsspulensystem 1.1 durch eine entsprechend anders arbeitende Sensoreinheit zu ersetzen.

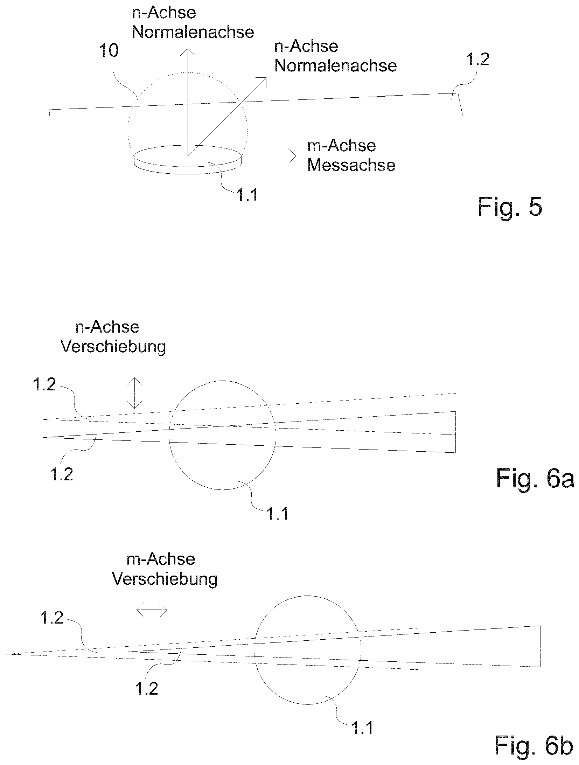

Bei einem induktiven Annäherungssensor ist zur Ermittlung wenigstens eines physikalischen Parameters wenigstens eines Targets 1.2 - z.B. werden Position oder Materialbeschaffenheit des Targets detektiert -, das in den Figuren 5 bis 6b dargestellt ist, gemäß Fig. 3 wenigstens ein Sende-/Empfangsspulensystem 1.1 als Sensoreinheit vorgesehen. Das Sende-/Empfangsspulensystem 1.1 bildet einen Detektionsbereich 10 gemäß Fig. 5 aus. Ein Sendetreiber 1.3 speist eine periodische Anregung 1.4 mit einer Sendefrequenz von z.B. 200 kHz in die Sendespule des Sende-/Empfangsspulensystems 1.1 ein. Das Anregungssignal zum Sende-/Empfangsspulen-system kann z.B. ein Rechteck- oder Sinussignal sein. Das Sende-/Empfangsspulen-system ist geometrisch so geformt und/oder so kalibriert, dass das von der Anregung 1.4 ausgehende Empfangssignal ohne Target im Detektionsbereich 10 Null oder nahezu Null ist. Im Ausführungsbeispiel der Fig. 3 bewirkt ein Target im Detektionsbereich 10 eine induktive Wirkung und damit ein Signal ungleich Null im Empfangspfad als Ausgangssignal 1.7 des Sende-/Empfangsspulensystems 1.1, wobei dieses Signal eine bestimmte Amplitude und Phase aufweist.

Der Aufbau von Sende- und Empfangsspule kann grundsätzlich z.B. wie in der deutschen Patentanmeldung DE 10 2012 001 202 A1 sein. Im Wesentlichen sind dabei die normalerweise kreisförmigen Windungen einer Spule in Mäanderform ausgebildet. Dabei ist die Sendespule zur Empfangsspule hin leicht im Rotationswinkel versetzt.

Hinsichtlich Amplitude und Phase als auch hinsichtlich des konkreten Aufbaus der Sende/Empfangsspulen-systems mit Sendespule und Empfangsspule wird auf die Erläuterung in der WO 2012/104 086 A1 verwiesen, wenngleich dort noch mit einer analogen Regelung gearbeitet wird. Zusammengefasst ergibt sich daraus, dass die Anregung 1.4 durch den Sendetakt periodisch getaktet wird, sodass ein Target 1.2 im Detektionsbereich 10 eine Amplitude und Phase bewirkt, das zu einem Ausgangs- oder Empfangssignal führt. Dieses Signal wird nach entsprechender, im Folgenden noch zu beschreibender Auswertung an den Mikrocontroller 1.10 übermittelt, der den Regelungstreiber 1.5 im geschlossenen Regelkreis so ansteuert, dass im Empfangspfad ein Regelsignal 1.6 so eingespeist wird, dass das Signal im Empfangspfad kompensiert wird und Null oder nahezu Null ist. Das Signal im Empfangspfad kann vor der Demodulation noch nahezu beliebig mittels Verstärker 13.4 verstärkt werden, da grundsätzlich nur die Abweichung zum ausgeregelten Zustand im Signal vorhanden ist. Die Signalaufbereitung und Interpretation der Messwerte sowie die Regelung wird durch den Mikrocontroller 1.10 umgesetzt.

Der Regelungstreiber 1.5 sorgt mit seinem Regelsignal 1.6 grundsätzlich dafür, dass ein Signal ungleich Null, das im Empfangspfad zum Beispiel durch ein Target 1.2 ausgelöst wird, zu Null ausgeregelt wird. Das Regelsignal bildet demnach exakt die elektromagnetische Wirkung des Targets 1.2 auf das Sende-/Empfangsspulen-system ab. Dem Regelsignal 1.6 ist dabei eine Abweichung $\Delta x$, $\Delta y$ vom ausgeregelten Zustand als Information zur induktiven Detektion des Targets immanent. Diese Information kann noch entsprechend ausgewertet werden.

Gemäß Fig. 5, 6a, 6b wird dazu als Messgröße, die auf die induktive Signatur wirkt, also darauf wie sich die Abweichungen Δx und Δy zum Beispiel in einer Vierquadrantendarstellung darstellen, eine sich entlang einer Messrichtung m veränderliche Form eines Targets 1.2 verwendet. In Fig. 5, 6a, 6b handelt es sich um ein sich in einer oder gegen eine bestimmten Messrichtung m verjüngendes Target 1.2. Anstelle der Verjüngung des Targets sind auch andere Formen und inhomogene Legierungen oder Materialkombinationen denkbar, die sich auf die induktive Signatur auswirken. Zum Beispiel kann das Target auch stufenweise seine Form in Messrichtung m ändern. Denkbar ist ebenso, dass sich die Zusammensetzung des Targets 1.2 entlang der Messrichtung m ändert, indem zum Beispiel eine inhomogene Legierung verwendet wird. Ebenso können Leiterbahnen und/oder Schwingkreise als Target verwendet werden. Wesentlich ist lediglich, dass das Sende/Empfangsspulen-system 1.1 als Sensoreinheit einen Detektionsbereich 10 aufweist und so beschaltet ist, dass am Ausgang des Sende-/Empfangsspulensystems 1.1 ohne Metalleinfluss im Detektionsbereich das Ausgangssignal ein Nullsignal ist. Befindet sich im Detektionsbereich 10 ein Target 1.2 ist das Ausgangssignal ein Signal ungleich Null, das eine bestimmte Amplitude und Phase aufweist.

Die Abweichungen Δx, Δy des Regelsignals werden in einem x-, y-Koordinatensys-tem in einer Vierquadrantendarstellung aufgetragen, wobei der Ursprung 2.7 des x-, y-Koordinatensystems dem ausgeregelten Zustand des Sende-/Empfangsspulen-systems 1.1 entspricht, in dem die Regelsignale Null sind bzw. zu Null kalibriert sind. In dieser Vierquadrantendarstellung der Abweichung Δx und der Abweichung Δy des Regelsignals ist der Winkel eines gedachten Vektors 2.6 zur x-Achse des x-, y-Koordinatensystems, welcher Vektor vom Ursprung 2.7 zu einem Messpunkt 2.5 führt, ein Maß für die Bewegung des Targets 1.2 in Messrichtung m ist. Der Betrag des gedachten Vektors 2.6 ist ein Maß für den Abstand des Targets 1.2 normal zur Messrichtung m. Von Bedeutung ist dabei, dass die Regelwerte und nicht die erfassten Ausgangssignale, also z.B. das Signal ungleich Null, der Sensoreinheit für die Auswertung im Rahmen der Vierquadrantendarstellung verwendet werden.

In diesem Ausführungsbeispiel wird im Rahmen eines Motionsensors die Position oder Lage eines bestimmten hinsichtlich seiner Form und/oder Legierung bekannten Targets bestimmt, indem z.B. gemäß Fig. 5 die Position des Targets entlang der m-Achse und der Abstand zur m-Achse bestimmt wird. Die Funktionsweise der Sensoreinheit kann aber auch als Annäherungssensor genutzt werden, d.h. es liegt kein bekanntes Target vor, sondern ein Objekt befindet sich im oder bewegt sich z.B. in den Detektionsbereich 10 des Sensors. In diesem Fall ist der Betrag des gedachten Vektors ein Maß für den Abstand des Objekts zur Sensoreinheit und der Winkel des gedachten Vektors 2.6 zur x-Achse des x-, y-Koordinatensystems eine Signatur des Materials, d.h. die Charakteristik des Materials spiegelt sich in dieser Signatur wieder, so dass z.B. Größe und/oder Beschaffenheit/Material des Objekts daraus bestimmt werden können. Ein Einsatzbereich ist z.B. auch die Erkennung von Rost an Eisen bei einem nicht von außen zugänglichen Material, wie z.B. Bewehrungsstahl in Beton.

Bei einer kapazitiven Ausführungsform führen Änderungen im elektrischen Feld bei Anwesenheit eines bekannten Targets aber auch bei Vorhandensein oder Bewegung eines Objekts im Detektionsbereich ebenfalls zu Änderungen der Regelwerte, die im Rahmen einer Vektoranalyse analog wie oben beschrieben ausgewertet werden können. Ein Einsatzbereich für eine kapazitive Messung ist z.B. die Feuchtebestimmung in Beton oder eines Estrichs.

Ähnlich verhält es sich aber auch mit anderen Messverfahren. Sofern die Regelwerte zur Ausregelung von Änderungen im Detektionsbereich und nicht die Ausgangssignale der Sensoreinheit in einer Vierquadrantendarstellung aufgetragen werden, ergeben sich aus diesen Regelwerten charakteristische Signaturen für diese Änderungen sowie Lageinformationen, die eine Objekterkennung und -unterscheidung möglich machen.

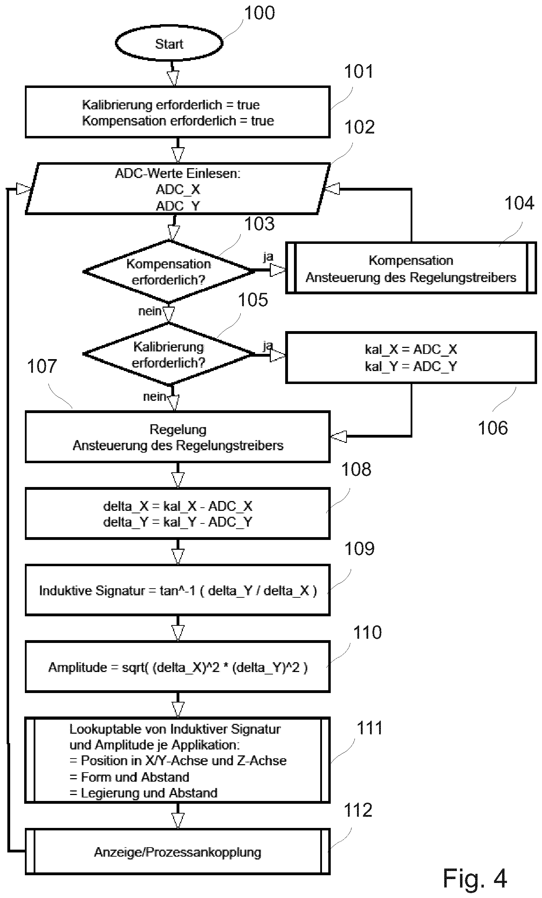

Der Verfahrensablauf wird anhand des Ablaufdiagramms gemäß Fig. 4 erläutert. Nach dem Start des Systems in Schritt 100 erfolgt zunächst eine Kalibrierung und gegebenenfalls Kompensierung gemäß Schritt 101. Dazu werden in Schritt 102 die Werte des Analog-Digitalwandlers 1.9 eingelesen. Abhängig von den gemessenen Werten wird in Schritt 103 überprüft, ob eine Kompensation erforderlich ist. Der Mikrocontroller 1.10 gibt insofern für den Regelungstreiber 1.5 in Schritt 104 Werte vor, um eventuelle Toleranzen des Systems auszugleichen. Dieser Vorgang wird für beide Phasen des Sendetakts so lange durchgeführt, bis die Werte der AD-Wandlung einen vorgegebenen Wert, zum Beispiel die Mitte des AD-Wandlerdynamikbereichs erreichen. In der Regel dauert dieser Vorgang nur wenige Millisekunden. Danach sind die Toleranzen des Spulensystems und eventuelle Umgebungseinflüsse kompensiert. Ergibt sich dann in Schritt 105, dass eine Kalibrierung erforderlich ist, werden in Schritt 106 die gemessenen Werte der AD-Wandlung gespeichert und dienen fortan als kalibrierter Nullpunkt des Systems.

Jetzt beginnt die eigentliche Messung, das heißt, es wird die Einwirkung des Targets 1.2 auf das induktive System gemessen. Diese Einwirkung führt zur Abweichung Δx und Δy vom kalibrierten Nullpunkt gemäß Schritt 108. Aus diesen Abweichungen lässt sich die induktive Signatur ermitteln, das heißt ein Maß für die induktive Wirkung des Targets 1.2 in Messrichtung m gemäß Schritt 109 sowie ein Maß für den Abstand des Targets 1.2 vom ausgeregelten Zustand normal zur Messrichtung m gemäß Schritt 110. Diese Werte können in einer Wertetabelle gemäß Schritt 111 kreuzreferenziert werden, um zum Beispiel die Legierung des Materials zu bestimmen. Sie können aber z.B. auch zur Bestimmung von Position, Form und Abstand des Targets 1.2 in den Messrichtungen dienen. Die so ermittelten Werte können angezeigt werden gemäß Schritt 112. Ohne bekanntes Target können alternativ die Annäherung eines Objekts und dessen Signatur in obigem Sinne ebenso bestimmt werden, gleich bei welchem Messverfahren. Das Verfahren läuft kontinuierlich, das heißt, nach Schritt 112 springt das System zu Schritt 102. Diese kontinuierliche Regelung endet vorzugsweise erst bei Außerbetriebnahme des Systems.

Zurück in Fig. 5 wird ein Aufbau mit einem keilförmigen, sich verjüngenden Target und einem Sende-/Empfangsspulensystem 1.1 gezeigt. Das Koordinatensystem m, n, n wird für diese Anmeldung so verwendet, dass ausgehend vom Sende-/ Empfangsspulensystem 1.1 die m-Achse eine Positionsänderung zu diesem System entlang einer Messachse definiert, während eine Positionsänderung entlang einer der n-Achsen eine zu dieser Messachse normal verlaufende Positionsänderung eines Targets ist. Eine Bewegung entlang einer der n-Achsen verändert also den Abstand des Targets 1.2 zum Sende-/Empfangsspulensystem. Die beiden n-Achsen stehen insofern normal zur m-Achse. Fig. 5 zeigt eine dreidimensionale Seitenansicht auf ein derartiges System, Fig. 6a, 6b eine Draufsicht. Eine Bewegung des Targets 1.2 in die gestrichelte Darstellung in Fig. 6a ist insofern eine Bewegung entlang der n-Achse und zeigt z.B. gegenüber dem Sende-/Empfangsspulensystem 1.1. eine Verschiebung quer zur m-Achse. Eine Bewegung gemäß Fig. 6b ist hingegen eine Bewegung in Richtung der m-Achse, die vorzugsweise die Messrichtung ist.

Das Target 1.2 ist in den Figuren nur schematisch dargestellt. Innerhalb bestimmter Grenzen ist das Messsystem für Messungen entlang der Messrichtung, der m-Achse, unabhängig gegenüber Toleranzen auf der n-Achse.

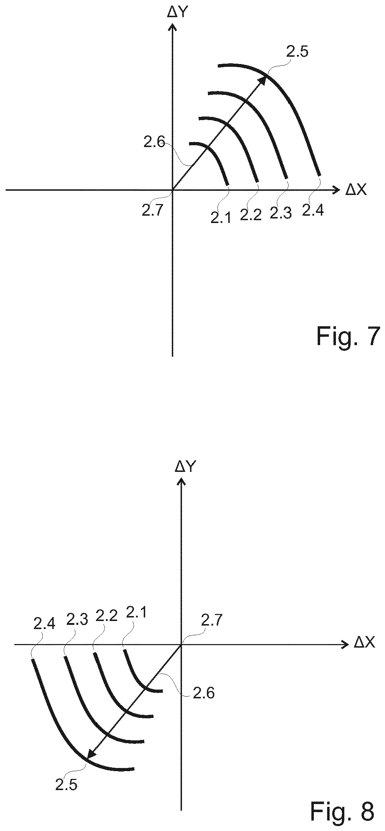

Fig. 7 und 8 zeigen die Darstellung der Signale in einer Vierquadrantendarstellung. Die Messwertkurven 2.1 bis 2.4 ergeben sich durch ein Durchfahren eines keilförmigen Targets durch den Detektionsbereich 10 entlang der m-Achse bei vier verschiedenen Abständen zur m-Achse. Es ist erkennbar, dass mit kleiner werdendem Abstand sich die Kurve von der Messwertkurve 2.1 bis zur Messwertkurve 2.4 vom Ursprung 2.7 entfernt. Die Kurve 2.1 zeigt also den Signalverlauf bei großem Abstand des Targets zum Sensor, die Kurve 2.4 den Signalverlauf bei geringem Abstand des Targets zum Sensor. Gleichzeitig ist zu erkennen, dass die Kurven dabei skaliert werden. Bei einer Verschiebung des Targets 1.2 in Messrichtung m ohne Verschiebung in einer Richtung normal zur Messrichtung m wie zum Beispiel in Richtung der n-Achse verändert sich die Richtung eines gedachten Vektors 2.6 bzw. der Winkel zwischen der x-Achse und einem gedachten Vektor 2.6 vom Ursprung 2.7 zum Messpunkt 2.5. Somit stellt die Richtung des Vektors ausschließlich ein Maß für die Bewegung des Targets 1.2 in Messrichtung m dar. In der Praxis bedeutet dies z.B. dass ein Target mit einer Länge von ca. 50 mm und einer Verjüngung von 7 mm auf 2 mm eine Winkelveränderung des Vektors zur x-Achse von 21,5°auf 46,2° auslöst.

Bei einer Bewegung normal zur Messrichtung m und damit in n-Richtung ohne Verschiebung entlang der m-Achse verändert sich der Betrag des gedachten Vektors 2.6 vom Ursprung 2.7 zum Messpunkt 2.5. Der Betrag des Vektors beschreibt den Abstand des Targets zum Spulensystem. Die Richtung des Vektors, die die induktive Signatur beschreibt, bleibt jedoch gleich. Damit präsentiert der Betrag des Vektors ausschließlich die Position des Targets, d.h. den Abstand des Targets zum Spulensystem.

Der in Fig. 7 gezeigte Signalverlauf ist nur beispielhaft. Bei Targets unterschiedlicher Materialen oder Formen können Signale auch in anderen Quadranten bzw. mit anderen targetspezifischen Signalverläufen entstehen. So zeigt zum Beispiel Fig. 8 eine Darstellung im dritten Quadranten.

Um aus diesen Darstellungen nun Position und Abstand des Targets 1.2 zum Spulensystem zu bestimmen, werden die gemäß Fig. 4 ermittelten Abweichungen $\Delta x$, $\Delta y$ des Regelsignals dahingehend interpretiert, dass in Schritt 108 sich der Betrag des Vektors $B_V$ aus dem quadratischen Mittelwert der Abweichungen zum kalibrierten Nullpunkt ergibt, das heißt zu:

$$B_V = \sqrt{\Delta X^2 + \Delta Y^2}$$

Formel 1

Dieser Betrag des Wertes entspricht dem Abstand des Targets 1.2 zum Spulensystem. Die Position des Targets entlang der m-Achse ergibt sich aus der Richtung des gedachten Vektors 2.6 zu:

$$S_l = \tan^{-1}\left(\frac{\Delta Y}{\Delta X}\right)$$

Formel 2

$S_i$ steht für induktive Signatur und entspricht der Position entlang der-m-Achse. Die Werte $B_v$ und $s_i$ können als Zahlenwerte für weitere Anwendungen verwendet werden. Durch spezielle für die entsprechende Applikation erstellte Algorithmen bzw. eine dafür erstellte Wertetabelle, in der Normwerte von Amplitude und induktiver Signatur gespeichert sind, kann je nach Applikation auf verschiedene Messgrößen gemäß Schritt 111 geschlossen werden. Mögliche Messgrößen sind bei Verwendung eines Targets beispielsweise:

- Position eines Targets entlang der m-Achse und Abstand zur m-Achse
- Legierung und Abstand eines Targets
- Form und Abstand eines Targets

Die erste Messgröße ($S_i$) ist durch die Richtung des gedachten Vektors 2.6 bzw. dessen Winkel zur x-Achse und die zweite Messgröße ($B_v$) durch den Betrag dieses Vektors bestimmt.

Ohne Target ergeben sich bei Vorhandensein und/oder Bewegung eines Objekts im Detektionsbereich - und zwar unabhängig vom jeweiligen physikalischen Parameter - durch die Richtung des gedachten Vektors 2.6 bzw. dessen Winkel zur x-Achse eine Messgröße für die Signatur des Gegenstands, also z.B. insbesondere Größe und Charakteristik/Beschaffenheit des Materials des Objekts, während durch den Betrag dieses Vektors der Abstand von der Sensoreinheit bestimmbar ist.

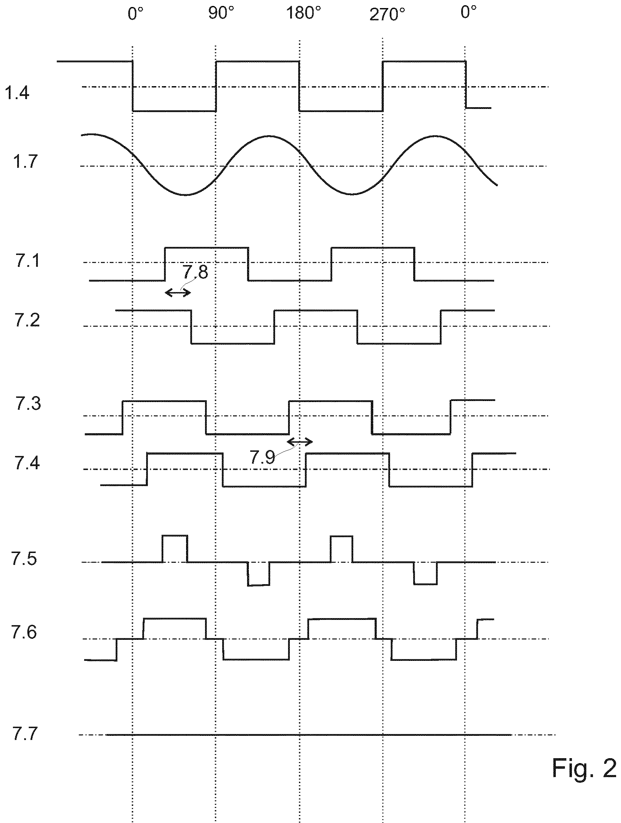

Fig. 2 zeigt die Signalverläufe bei der Ermittlung eines Korrektursignals zur Kompensation eines von der Anregung 1.4 im Sende-/ Empfangsspulensystem 1.1 erzeugten und durch die Anwesenheit eines Targets 1.2 beeinflussten Ausgangssignal 1.7 der Sensoreinheit. Dieses Ausgangssignal 1.7 wird z.B. durch Filter im Wesentlichen auf die Grundwelle der Anregung 1.4 reduziert. Mittels wenigstens einer Pulsweitenmodulation wird je ein Korrektursignal 7.5, 7.6 mit variabler Pulsbreite und ggf. variabler Phase erzeugt und zum Ausgangssignal 1.7 des Sende-/Empfangsspulensystems 1.1 addiert und dadurch das Ausgangssignal im gesamten Phasenraum zu Null oder nahezu Null geregelt.

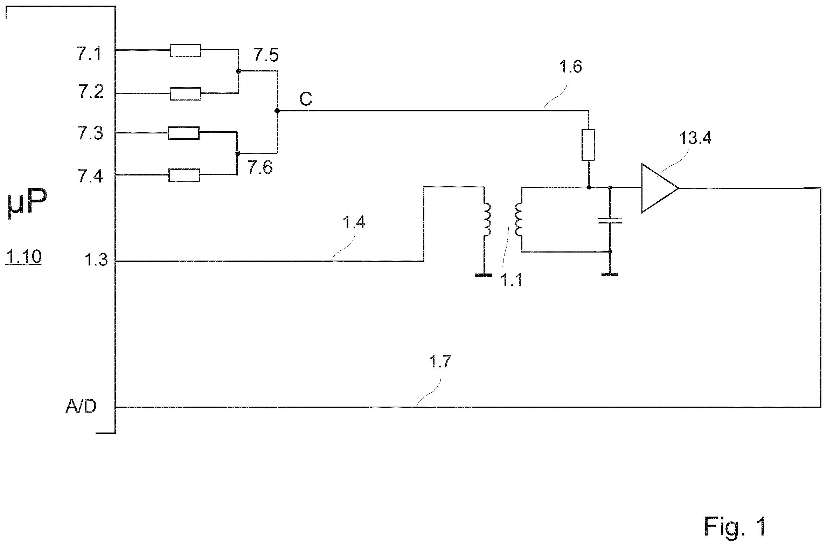

Das Verfahren kann mit nur einer Pulsweitenmodulation betrieben werden, bei der Pulsweite und Zeitpunkt variabel sind. Vorzugsweise sind jedoch mehrere Pulsweitenmodulationen vorgesehen, die Korrektursignalanteile als Einzelsignale erzeugen, deren Summe das Korrektursignal bildet, wobei jede Pulsweitenmodulation symmetrisch um einen Phasenpunkt herum die Pulsbreite des Korrektursignals bestimmt, d.h. das Einzelsignal erstreckt sich ausgehend von einem ermittelten Punkt zeitlich in beide Richtungen und wird nicht von einem Punkt aus zeitlich nur in einer Richtung in der Länge gedehnt. Die Pulsweitenmodulation wird also selbst als Signal verwendet, wobei bei mehreren Pulsweitenmodulationen die Einzelsignale zueinander verschoben die eigentliche Pulsweitenmodulation ergeben, indem sie außerhalb des die Pulsbreite und ggf. Phase des einzelnen Korrektursignalanteils erzeugenden Mikroprozessors 8 miteinander addiert werden. In Fig. 2 stellen die Signalverläufe 7.1, 7.2 eine erste Pulsweitenmodulation dar, wobei die Pulsbreite dadurch beeinflusst wird, dass die Pulse gemäß Pfeil 7.8 relativ zueinander verschoben werden. Die Signalverläufe 7.3, 7.4 bilden eine weitere Pulsweitenmodulation, in der die Pulsbreite dadurch beeinflusst wird, dass die Pulse gemäß Pfeil 7.9 relativ zueinander verschoben werden. Durch Summierung der Signalverläufe 7.1 und 7.2 bzw. 7.3 und 7.4 ergeben, wie auch in Fig. 1 dargestellt, sich die Korrektursignale 7.5 und 7.6, die miteinander zum Summensignal C summiert werden, das das Ausgangssignal der Sensoreinheit zum Signalverlauf 7.7. kompensiert.

Fig. 2 zeigt, dass die Korrektursignale 7.5 und 7.6, oder besser Korrektursignalanteile, als Tristatesignal erzeugt werden. Die Korrektursignale 7.5 und 7.6 und deren Zusammenfassung als Summensignal C erzeugen ein Multistatesignal. Die Korrektursignalanteile werden bei 0° und 180° bzw. bei 90° und 270° jeweils invertiert erzeugt. Bei mehreren Pulsweitenmodulationen, wie in Fig. 7, 8 dargestellt, werden die Pulsweiten bei den Phasenpunkten 0° und 180° unabhängig von den Phasenpunkten bei 90° und 270° bestimmt. Zudem können die Phasenpunkte bei 0°, 90°, 180° und 270° unabhängig von der Phase des Anregungssignals 1.4 gewählt werden.

Zur Umsetzung des Verfahrens wird das Ausgangssignal 1.7 an wenigstens zwei Abtastzeitpunkten im Phasenraum abgetastet, die um 90° zueinander versetzt sind. Vorzugsweise wird das Korrektursignal durch wenigstens einen ersten und zweiten Koeffizienten einer Fourieranalyse gebildet.

Der Eintrag eines Korrektursignals zu einem bestimmten Zeitpunkt bewirkt eine maximale Änderung des Ausgangssignals 1.7 zu einem anderen Zeitpunkt. Um eine optimale Wirkung des Korrektursignals zu erreichen, erfolgt die Abtastung zur Steuerung dieses Korrektursignals zu dem bestimmten Zeitpunkt, der der maximalen Änderung zuordenbar ist. In der Regel besteht also ein Zeitversatz zwischen dem aus den Korrektursignalen 7.5 und 7.6 addierten Summensignal C als Regelsignal 1.6 und dem Ausgangssignal 1.7.

Sind wie in Fig. 2 wenigstens vier Abtastzeitpunkte vorgesehen, werden die Werte zweier Abtastzeitpunkte, die um 180° versetzt sind, zueinander auf eine Differenz von Null geregelt.

Um den Temperatureinfluss der elektronischen Komponenten auszuschließen, wird das Signal ungleich Null im Empfangspfad direkt am Entstehungsort, d.h. an der Sensoreinheit bzw. hier am Sende-/ Empfangsspulensystem 1.1 zu Null ausgeregelt.

Die Werte von Korrektursignalanteilen ohne Target werden als Nullpunkt für die Messung bzw. als Nullpunkt für eine Vektoranalyse verwendet, wie sie eingangs beschrieben wurde. Das bedeutet, dass dem Regelsignal 1.6 wenigstens eine Abweichung $\Delta x$, $\Delta y$ des Regelsignals vom ausgeregelten Zustand als Information über die induktive Wirkung wie z.B. Art und/oder Position des Targets 1.2 relativ zum Sende-/Empfangsspulensystem (1.1) immanent ist.

Fig. 1 zeigt die Regelschleife des verfahrensgemäß betrieben Systems. Die Bestimmung des Regelsignals 1.6 erfolgt dadurch, dass in einer digitalen Auswertung die bei 0° und 180° bestimmte Signale 7.1, 7.2 einer ersten Pulsweitenmodulation zum Korrektursignal 7.5 summiert werden. Die bei 90° und 270° bestimmten Signale 7.3 und 7.4 einer zweiten Pulsweitenmodulation werden zum Korrektursignal 7.6 summiert. Die Summe der Korrektursignale 7.5 und 7.6 führt zum Summensignal C, der direkt an der Sensoreinheit, d.h. hier am Sende-/Empfangsspulensystem 1.1 auf das System einwirkt. Kommt es im Spulensystem zu Abweichungen des Ausgangssignals z.B. durch Metallannäherung, werden diese über den Verstärker 13.4 verstärkt, dem Mikroprozessor 8 als Ausgangssignal 1.7 zugeführt und dort erneut über die Pulsweitenmodulation ausgeregelt.

Die Summierungswiderstände können Teil des Spannungsteilers sein, um das der Empfangsspule zugeführte Signal auf entsprechend kleine Werte herunterzuteilen. In der Praxis hat sich jedoch ein einzelner hochohmiger Widerstand z.B. 330 kΩ direkt an der Sensoreinheit wie der Empfangsspule als vorteilhaft erwiesen, wobei die Summierungswiderstände dann z.B. 10 kΩ betragen. Jede andere Art von Spannungsteilung kann zur Reduzierung der eingebrachten Energie verwendet werden.

Abstrahiert auf eine beliebige Sensoreinheit wird also wenigstens ein physikalischer Parameter mittels einer Sensoreinheit ermittelt, die durch mindestens eine periodische Anregung 1.4 erregt wird. Die Sensoreinheit weist wenigstens einen Detektionsbereich 10 auf, in dem Änderungen des Parameters im Umfeld der Sensoreinheit zu einem Ausgangssignal 1.7 der Sensoreinheit führen. Die Sensoreinheit ist so beschaltet, dass am Ausgang der Sensoreinheit ohne Änderungen des Parameters im Detektionsbereich 10 das Ausgangssignal 1.7 ein Nullsignal oder ein nahezu Nullsignal ist, während bei Änderungen des Parameters im Detektionsbereich 10 das Ausgangssignal 1.7 ein Signal ungleich Null ist, das eine bestimmte Amplitude und Phase aufweist. In einem geschlossenen Regelkreis wird mit einem Regelsignal 1.6 das Signal ungleich Null im Empfangspfad auch bei Vorhandensein von Änderungen des Parameters im Detektionsbereich 10 zur Erzielung eines ausgeregelten Zustands zu Null ausgeregelt wird. Das Ausgangssignal 1.7 der Sensoreinheit wird im Wesentlichen auf die Grundwelle der Anregung 1.4 reduziert. Wenigstens eine Pulsweitenmodulation erzeugt je ein Korrektursignal mit variabler Pulsbreite und ggf. variabler Phase und addiert es zum Ausgangssignal 1.7 der Sensoreinheit und regelt dadurch das Ausgangssignal im gesamten Phasenraum zu Null. Die Pulsbreite des Korrektursignals und/oder die Phase des Korrektursignals wird durch die Abweichungen des Ausgangssignals 1.7 von Null bestimmt.

**Bezugszeichenliste**

| | |
|---|---|
| 1.1 | Sende-/Empfangsspulensystem |
| 1.2 | Target |
| 1.3 | Sendetreiber |
| 1.4 | Anregungssignal |
| 1.5 | Regelungstreiber |
| 1.6 | Regelsignal |
| 1.7 | Ausgangssignal/Empfangssignal |
| 1.8 | Demodulation |
| 1.9 | Analog-Digitalwandler |
| 1.10 | Mikrocontroller |
| 2.1 | Signalkurve |
| 2.2 | Signalkurve |
| 2.3 | Signalkurve |
| 2.4 | Signalkurve |
| 2.5 | Messpunkt |
| 2.6 | Vektor |
| 2.7 | Ursprung des Koordinatensystems |
| 7.1, 7.2, 7.3, 7.4 | Signalverläufe |
| 7.5, 7.6 | Korrektursignal |
| 7.7 | Signalverlauf |
| 7.8,7.9 | Pfeil |
| 10 | Detektionsbereich |
| 100 - 112 | Verfahrensschritte |
| m-m | Messrichtung |
| n | Richtung normal zur Messrichtung |
| C | Korrektur |
| Δx, Δy | Abweichung des Regelsignals |

**Patentansprüche**

1. Verfahren zur Ermittlung wenigstens eines physikalischen Parameters mittels einer Sensoreinheit, die durch mindestens eine periodische Anregung (1.4) erregt wird,

   wobei die Sensoreinheit wenigstens einen Detektionsbereich (10) aufweist, in dem Änderungen des Parameters im Umfeld der Sensoreinheit zu einem Ausgangssignal (1.7) der Sensoreinheit führen,

   wobei die Sensoreinheit so beschaltet ist, dass am Ausgang der Sensoreinheit ohne Änderungen des Parameters im Detektionsbereich (10) das Ausgangssignal (1.7) ein Nullsignal oder ein nahezu Nullsignal ist, während bei Änderungen des Parameters im Detektionsbereich (10) das Ausgangssignal (1.7) ein Signal ungleich Null ist, das eine bestimmte Amplitude und Phase aufweist,

   wobei in einem geschlossenen Regelkreis mit einem Regelsignal (1.6) das Signal ungleich Null im Empfangspfad auch bei Vorhandensein von Änderungen des Parameters im Detektionsbereich (10) zur Erzielung eines ausgeregelten Zustands zu Null ausgeregelt wird,

   wobei das Regelsignal (1.6) ausgewertet wird, um den physikalischen Parameter zu ermitteln,

   wobei das Ausgangssignal (1.7) der Sensoreinheit im Wesentlichen auf die Grundwelle der Anregung (1.4) reduziert wird und mittels wenigstens einer Pulsweitenmodulation das Ausgangssignal (1.7) im gesamten Phasenraum zu Null geregelt,

   **dadurch gekennzeichnet, dass** die wenigstens eine Pulsweitenmodulation selbst je ein Korrektursignal mit variabler Pulsbreite und ggf. variabler Phase erzeugt, das dann zum Ausgangssignal (1.7) der Sensoreinheit addiert wird und dadurch das Ausgangssignal im gesamten Phasenraum zu Null regelt,

   wobei die Pulsbreite des Korrektursignals und/oder die Phase des Korrektursignals durch die Abweichungen des Ausgangssignals (1.7) von Null bestimmt wird.

2. Verfahren nach Anspruch 1, **dadurch gekennzeichnet, dass** die Pulsweitenmodulation symmetrisch um einen Phasenpunkt herum die Pulsbreite des Korrektursignals bestimmt.

3. Verfahren nach Anspruch 1 oder 2, **dadurch gekennzeichnet, dass** mehrere zueinander verschiebbare Pulsweitenmodulationen vorgesehen sind, die Korrektursignalanteile als Einzelsignale erzeugen, deren Summe das Korrektursignal bildet, wobei jede Pulsweitenmodulation symmetrisch um einen Phasenpunkt herum die Pulsbreite des Korrektursignals bestimmt.

4. Verfahren nach Anspruch 3, **dadurch gekennzeichnet, dass** die Korrektursignalanteile bei 0° und 180° bzw. bei 90° und 270° jeweils invertiert erzeugt werden.

5. Verfahren nach Anspruch 3 oder 4, **dadurch gekennzeichnet, dass** die Pulsweiten bei den Phasenpunkten 0° und 180° unabhängig von den Phasenpunkten bei 90° und 270° bestimmt werden und/oder dass die Phasenpunkte bei 0°, 90°, 180° und 270° unabhängig von der Phase der Anregung (1.4) gewählt werden.

6. Verfahren nach einem der vorhergehenden Ansprüche, **dadurch gekennzeichnet, dass** das Ausgangssignal (1.7) an wenigstens zwei Abtastzeitpunkten im Phasenraum abgetastet wird, die um 90° zueinander versetzt sind.

7. Verfahren nach Anspruch 6, **dadurch gekennzeichnet, dass** der Eintrag eines Korrektursignals zu einem bestimmten Zeitpunkt mit einem erfassbaren Zeitversatz eine Änderung des Ausgangssignals (1.7) bewirkt, wobei ferner erfasst wird, zu welchem Zeitpunkt die Änderung des Ausgangssignals einen Maximalwert erreicht, und dass der Abtastzeitpunkt zur Steuerung dieses Korrektursignals mit dem Zeitversatz vor dem Zeitpunkt erfolgt, zu dem die Änderung des Ausgangssignals den Maximalwert erreicht.

8. Verfahren nach Anspruch 6 oder 7, **dadurch gekennzeichnet, dass** bei wenigstens vier Abtastzeitpunkten die Werte zweier Abtastzeitpunkte, die um 180° versetzt sind, zueinander auf eine Differenz von Null geregelt werden.

9. Verfahren nach einem der vorhergehenden Ansprüche 3 bis 8, **dadurch gekennzeichnet, dass** bei mehreren Pulsweitenmodulationen die Einzelsignale zueinander verschoben die eigentliche Pulsweitenmodulation ergeben, indem sie außerhalb des die Pulsbreite und ggf. Phase des einzelnen Korrektursignalanteils erzeugenden Mikroprozessors (8) miteinander addiert werden.

10. Verfahren nach einem der vorhergehenden Ansprüche, **dadurch gekennzeichnet, dass** das Signal ungleich Null im Empfangspfad direkt am Sensorkopf der Sensoreinheit zu Null ausgeregelt wird,

**11.** Verfahren nach einem der vorhergehenden Ansprüche, **dadurch gekennzeichnet, dass** das Korrektursignal durch wenigstens einen ersten und zweiten Koeffizienten einer Fourieranalyse gebildet wird.

**12.** Verfahren nach einem der vorhergehenden Ansprüche, **dadurch gekennzeichnet, dass** Werte von Korrektursignalanteilen ohne Target als Nullpunkt für eine Vektoranalyse verwendet werden.

**13.** Verfahren nach einem der vorhergehenden Ansprüche, **dadurch gekennzeichnet, dass** im Fall von Änderungen des Parameters im Detektionsbereich (10), wenn also das Ausgangssignal (1.7) ein Signal ungleich Null ist, dem Regelsignal (1.6) wenigstens eine Abweichung ($\triangle$x, $\triangle$y) des Regelsignals vom ausgeregelten Zustand als Information über den physikalischen Parameter oder die Eigenschaft immanent ist.

**14.** Verfahren nach einem der vorhergehenden Ansprüche, **dadurch gekennzeichnet, dass** zur induktiven Detektion wenigstens eines induktiv wirksamen Targets (1.2), das den physikalischen Parameter aufweist, als Sensoreinheit ein Sende/Empfangsspulensystem (1.1) durch die periodische Anregung (1.4) erregt wird, wobei das Sende-/ Empfangsspulensystem (1.1) wenigstens zwei Spulen und einen Detektionsbereich (10) aufweist, wobei das Sende-/ Empfangsspulensystem (1.1) so beschaltet ist, dass am Ausgang des Sende-/ Empfangsspulensystems (1.1) ohne Metalleinfluss das Ausgangssignal (1.7) ein Nullsignal oder ein nahezu Nullsignal ist, während bei einem Target (1.2) im Detektionsbereich (10) das Ausgangssignal (1.7) ein Signal ungleich Null ist, das die bestimmte Amplitude und Phase aufweist, wobei in einem geschlossenen Regelkreis mit einem Regelsignal (1.6) das Signal ungleich Null im Empfangspfad auch bei Vorhandensein des Targets (1.2) im Detektionsbereich (10) zur Erzielung eines ausgeregelten Zustands zu Null ausgeregelt wird, wobei das Regelsignal (1.6) ausgewertet wird, um das Target (1.2) zu detektieren.

**Claims**

**1.** A method for determining at least one physical parameter by means of a sensor unit that is excited by at least one periodic excitation (1.4), wherein the sensor unit has at least one detection region (10) in which changes in the parameter in the environment of the sensor unit result in an output signal (1.7) from the sensor unit,

wherein the sensor unit is connected such that, if there are no changes in the parameter in the detection region (10), the output signal (1.7) at the output of the sensor unit is a zero signal or a signal approximating to zero, whereas in the event of changes in the parameter in the detection region (10) the output signal (1.7) is a signal not equal to zero and having a particular amplitude and phase,
wherein in a closed-loop control circuit, the signal not equal to zero is compensated to give a zero value by a control signal (1.6) in the receive path, even if there are changes in the parameter in the detection region (10), for the purpose of achieving a compensated condition,
wherein the control signal (1.6) is evaluated to determine the physical parameter,
wherein the output signal (1.7) of the sensor unit is reduced substantially to the fundamental wave of the excitation (1.4) and the output signal (1.7) is controlled to give zero in the entire phase space by means of at least one pulse width modulation,
**characterized in that** at least one pulse width modulation itself each generates a correction signal of variable pulse width and where appropriate variable phase, and this is summed with the output signal (1.7) of the sensor unit, and hence controls the output signal to give zero in the entire phase space,
wherein the pulse width of the correction signal and/or the phase of the correction signal is determined by the deviations of the output signal (1.7) from zero.

**2.** A method according to Claim 1, **characterized in that** the pulse width modulation determines the pulse width of the correction signal symmetrically about a phase point.

**3.** A method according to Claim 1 or 2, **characterized in that** a plurality of mutually displaceable pulse width modulations is provided that generate correction signal components as individual signals whereof the sum forms the correction signal, wherein each pulse width modulation determines the pulse width of the correction signal symmetrically about a phase point.

**4.** A method according to Claim 3, **characterized in that** the correction signal components are generated at 0° and 180° and/or at 90° and 270°, in each case inverted.

**5.** A method according to Claim 3 or 4, **characterized in that** the pulse widths at the phase points 0° and 180° are determined independently of the phase points at 90° and 270°, and/or the phase points at 0°, 90°, 180° and 270° are selected independently of the phase of the excitation (1.4).

**6.** A method according to one of the preceding claims, **characterized in that** the output signal (1.7) is scanned, at at least two scanning time points in the phase space which are offset from one another by 90°.

**7.** A method according to Claim 6, **characterized in that** the input of a correction signal at a particular point in time with a detectable time offset brings about a change in the output signal (1.7), wherein the point in time at which the change in the output signal reaches a maximum value is further detected, and **in that** the scanning point in time occurs, for control of this correction signal, with the time offset before the point in time at which the change in the output signal reaches the maximum value.

**8.** A method according to Claim 6 or 7, **characterized in that**, with at least four scanning time points, the values of two scanning time points that are offset by 180° are controlled in relation to one another to give a difference of zero.

**9.** A method according to one of the preceding Claims 3 to 8, **characterized in that**, with a plurality of pulse width modulations, the individual signals, displaced in relation to one another, give the actual pulse width modulation by being summed with one another outside the microprocessor (8) that generates the pulse width and where appropriate the phase of the individual correction signal component.

**10.** A method according to one of the preceding claims, **characterized in that** the signal not equal to zero in the receive path is compensated to zero directly at the sensor head of the sensor unit.

**11.** A method according to one of the preceding claims, **characterized in that** the correction signal is formed by at least a first and a second coefficient of a Fourier analysis.

**12.** A method according to one of the preceding claims, **characterized in that** values of correction signal components without a target are used as a zero point for a vector analysis.

**13.** A method according to one of the preceding claims, **characterized in that** in the event of changes in the parameter in the detection region (10), thus if the output signal (1.7) is a signal not equal to zero, at least one deviation ($\Delta$x, $\Delta$y) of the control signal from the compensated condition is inherent in the control signal (1.6), as an item of information on the physical parameter or the property.

**14.** A method according to one of the preceding claims, **characterized in that**, for the inductive detection of at least one target (1.2) that has an inductive effect and has the physical parameter, as a sensor unit a transmitting/receiving coil system (1.1) is excited by the periodic excitation (1.4), wherein the transmitting/receiving coil system (1.1) has at least two coils and a detection region (10),
wherein the transmitting/receiving coil system (1.1) is connected such that in the absence of the influence of metal at the output of the transmitting/receiving coil system (1.1) the output signal (1.7) is a zero signal or a signal approximating to zero, while if there is a target (1.2) in the detection region (10), the output signal (1.7) is a signal that is not equal to zero and has the particular amplitude and phase,
wherein, in a closed-loop control circuit, the signal not equal to zero is compensated to give a zero value by a control signal (1.6) in the receive path, even if there are changes in the target (1.2) in the detection region (10), for the purpose of achieving a compensated condition,
wherein the control signal (1.6) is evaluated in order to detect the target (1.2).

**Revendications**

**1.** Procédé pour mesurer au moins un paramètre physique au moyen d'une unité de détection, laquelle est excitée par au moins une excitation périodique (1.4), dans lequel l'unité de détection présentant au moins une zone de détection (10) dans laquelle des variations du paramètre dans l'environnement de l'unité de détection induisent un signal de sortie (1.7) de l'unité de détection,
dans lequel l'unité de détection étant câblée de telle sorte qu'à la sortie de l'unité de détection, le signal de sortie (1.7) est un signal nul ou quasiment nul en l'absence de variations du paramètre dans la zone de détection (10), tandis qu'en cas de variations du paramètre dans la zone de détection (10), le signal de sortie (1.7) est un signal différent de zéro, qui présente une amplitude et une phase déterminées,

dans lequel, dans un circuit de réglage fermé avec un signal de réglage (1.6), le signal différent de zéro dans le chemin de réception est réglé à zéro même en cas de variations du paramètre dans la zone de réception (10) en vue d'atteindre un état réglé,

dans lequel le signal de réglage (1.6) est exploité pour mesurer le paramètre physique,

dans lequel le signal de sortie (1.7) de l'unité de détection est réduit essentiellement à l'onde de base de l'excitation (1.4) et le signal de sortie (1.7) est réglé à zéro dans l'ensemble de l'espace des phases au moyen d'au moins une modulation d'impulsion en largeur,

**caractérisé en ce que** la ou les modulation d'impulsion en largeur produit/sent elle(s)-même(s) un signal de correction respectif avec une largeur d'impulsion variable et, le cas échéant, avec une phase variable, lequel signal de correction est ajouté au signal de sortie (1.7) de l'unité de détection et, ainsi, le signal de sortie est réglé à zéro dans l'ensemble de l'espace des phases,

dans lequel la largeur d'impulsion du signal de correction et/ou la phase du signal de correction est/sont déterminée(s) par les écarts du signal de sortie (1.7) par rapport à zéro.

2. Procédé selon la revendication 1, **caractérisé en ce que** la modulation d'impulsion en largeur détermine symétriquement autour d'un point de phase la largeur d'impulsion du signal de correction.

3. Procédé selon la revendication 1 ou 2, **caractérisé en ce que** plusieurs modulations d'impulsion en largeur déplaçables les unes vers les autres sont prévues, lesquelles produisent des fractions de signal de correction dont la somme forme le signal de correction, chaque modulation d'impulsion en largeur déterminant symétriquement autour du point de phase la largeur d'impulsion du signal de correction.

4. Procédé selon la revendication 3, **caractérisé en ce que** les fractions de signal de correction sont produites de manière inversée respectivement à 0 et 180 degrés ou à 90 et 270 degrés.

5. Procédé selon la revendication 3 ou 4, **caractérisé en ce que** les largeurs d'impulsion sont déterminées au niveau des points de phase à 0 et 180 degrés indépendamment des points de phase à 90 et 270 degrés et/ou **en ce que** les points de phase à 0, 90, 180 et 270 degrés sont choisis indépendamment de la phase de l'excitation (1.4).

6. Procédé selon l'une des revendications précédentes, **caractérisé en ce que** le signal de sortie (1,7) est prélevé dans l'espace des phases à au moins deux points de prélèvement qui sont décalés l'un par rapport à l'autre de 90 degrés.

7. Procédé selon la revendication 6, **caractérisé en ce que** l'entrée d'un signal de correction à un moment déterminé produit avec un décalage temporel mesurable une variation du signal de sortie (1.7) et il est en outre mesuré à quel moment la variation du signal de sortie atteint une valeur maximale, et **en ce que** le point de prélèvement se situe, en vue de commander ce signal de correction, avec le décalage temporel avant le moment où la variation du signal de sortie atteint la valeur maximale.

8. Procédé selon la revendication 6 ou 7, **caractérisé en ce que** dans le cas où il y a au moins quatre points de prélèvement, les valeurs de deux points de prélèvement, qui sont décalés de 180 degrés, sont réglés avec une différence de zéro entre eux.

9. Procédé selon l'une des revendications précédentes 3 à 8, **caractérisé en ce que** dans le cas où il y a plusieurs modulations d'impulsion en largeur, les signaux individuels décalés les uns par rapport aux autres donnent la véritable modulation d'impulsion en largeur, tandis qu'ils s'ajoutent les uns aux autres à l'exception du microprocesseur (8) produisant les largeurs d'impulsion et le cas échéant la phase de la fraction de signal de correction respective.

10. Procédé selon l'une des revendications précédentes, **caractérisé en ce que** le signal différent de zéro est réglé à zéro dans le chemin de réception directement au niveau de la tête de détection de l'unité de détection.

11. Procédé selon l'une des revendications précédentes, **caractérisé en ce que** le signal de correction est formé d'au moins un premier coefficient et un second coefficient d'une analyse de Fourier.

12. Procédé selon l'une des revendications précédentes, **caractérisé en ce que** les valeurs de fractions de signal de correction sont utilisées sans cible en tant que point zéro pour une analyse vectorielle.

**13.** Procédé selon l'une des revendications précédentes, **caractérisé en ce que**, en cas de variations du paramètre dans la zone de détection (10), lorsque le signal de sortie (1.7) est donc aussi un signal différent de zéro, au moins un écart ($\Delta$x, $\Delta$y) du signal de réglage par rapport à l'état réglé est immanent au signal de réglage (1.6) en tant qu'information sur le paramètre physique ou la propriété.

**14.** Procédé selon l'une des revendications précédentes, **caractérisé en ce qu'**un système de bobine d'émission/réception (1.1) est excité en tant qu'unité de détection par l'excitation périodique (1.4) en vue de la détection inductive d'au moins une cible (1.2) agissant par induction et présentant le paramètre physique, le système de bobine d'émission/réception (1.1) présentant au moins deux bobines et une zone de détection (10),
dans lequel le système de bobine d'émission/réception (1.1) est câblé de manière à ce qu'au niveau de la sortie du système de bobine d'émission/réception (1.1), le signal de sortie (1.7) est un signal nul ou presque nul sans influence métallique, tandis qu'en cas de présence d'une cible (1.2) dans la zone de détection (10), le signal de sortie (1.7) est un signal différent de zéro, lequel présente l'amplitude et la phase déterminées,
dans lequel, dans un circuit de réglage fermé avec un signal de réglage (1.6), le signal différent de zéro est réglé à zéro dans le chemin de réception même en cas de présence de la cible (1.2) dans la zone de détection (10) pour l'obtention d'un état réglé, le signal de réglage (1.6) étant exploité pour détecter la cible (1.2).

Fig. 1

Fig. 2

Fig. 3

100 Start

101 Kalibrierung erforderlich = true
Kompensation erforderlich = true

102 ADC-Werte Einlesen:
ADC_X
ADC_Y

103 Kompensation erforderlich?

104 Kompensation
Ansteuerung des Regelungstreibers

ja

nein

105 Kalibrierung erforderlich?

106 kal_X = ADC_X
kal_Y = ADC_Y

ja

nein

107 Regelung
Ansteuerung des Regelungstreibers

108 delta_X = kal_X - ADC_X
delta_Y = kal_Y - ADC_Y

109 Induktive Signatur = tan^-1 ( delta_Y / delta_X )

110 Amplitude = sqrt( (delta_X)^2 * (delta_Y)^2 )

111 Lookuptable von Induktiver Signatur
und Amplitude je Applikation:
= Position in X/Y-Achse und Z-Achse
= Form und Abstand
= Legierung und Abstand

112 Anzeige/Prozessankopplung

Fig. 4

n-Achse
Normalenachse

10

n-Achse
Normalenachse

1.2

m-Achse
Messachse

1.1

Fig. 5

n-Achse
Verschiebung

1.2

1.2

1.1

Fig. 6a

m-Achse
Verschiebung

1.2

1.2

1.1

Fig. 6b

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012019329 A
- DE 102013226887
- US 5729 A
- US 143 A
- US 4030026 A
- DE 102012001202 A1
- WO 2012104086 A1